(19) Europäisches Patentamt European Patent Office Office européen des brevets

(11) **EP 2 068 442 B1**

(12) **EUROPEAN PATENT SPECIFICATION**

(45) Date of publication and mention
of the grant of the patent:
**28.09.2016 Bulletin 2016/39**

(21) Application number: **07806505.9**

(22) Date of filing: **31.08.2007**

(51) Int Cl.:
*H03H 9/145* (2006.01)      *H03H 9/25* (2006.01)
*H03H 9/02* (2006.01)

(86) International application number:
**PCT/JP2007/067032**

(87) International publication number:
**WO 2008/038493 (03.04.2008 Gazette 2008/14)**

(54) **BOUNDARY ACOUSTIC WAVE DEVICE**

GRENZSCHALLWELLENVORRICHTUNG

DISPOSITIF À ONDE ACOUSTIQUE LIMITE

(84) Designated Contracting States:
**AT BE BG CH CY CZ DE DK EE ES FI FR GB GR
HU IE IS IT LI LT LU LV MC MT NL PL PT RO SE
SI SK TR**

(30) Priority: **25.09.2006 JP 2006259023**

(43) Date of publication of application:
**10.06.2009 Bulletin 2009/24**

(73) Proprietor: **MURATA MANUFACTURING CO., LTD.
Nagaokakyo-shi, Kyoto 617-8555 (JP)**

(72) Inventors:
 • **MIMURA, Masakazu
   Nagaokakyo-shi, Kyoto; 617-8555 (JP)**
 • **FUJII, Yasuhisa
   Nagaokakyo-shi, Kyoto; 617-8555 (JP)**

 • **YATA, Masaru
   Nagaokakyo-shi, Kyoto; 617-8555 (JP)**
 • **NAKAHASHI, Norihiko
   Nagaokakyo-shi, Kyoto; 617-8555 (JP)**

(74) Representative: **Delumeau, François Guy et al
Cabinet Beau de Loménie
158, rue de l'Université
75340 Paris Cedex 07 (FR)**

(56) References cited:
**EP-A1- 1 696 562       EP-A2- 1 538 748
WO-A1-2005/060094   WO-A1-2005/093949
DE-A1- 4 132 309       DE-A1-102004 058 016
JP-A- 2001 077 658**

## Description

Technical Field

The present invention relates to a boundary acoustic wave device using a boundary acoustic wave which propagates along a boundary between a first medium and a second medium, which have different acoustic velocities, and more particularly relates to a boundary acoustic wave device having a structure which includes a piezoelectric substance composed of $LiNbO_3$ and a dielectric substance composed of a silicon oxide laminated thereto.

Background Art

In recent years, as a band pass filter used in the RF stage of a mobile phone, various surface acoustic wave filters and boundary acoustic wave filters have been proposed. In a boundary acoustic wave filter, a boundary acoustic wave propagating along a boundary between a piezoelectric substance and a dielectric substance is used. Accordingly, since a package having a cavity is not necessary, the size of the boundary acoustic wave filter can be reduced.

The following Patent Document 1 has disclosed one example of this type of boundary acoustic wave device. In the boundary acoustic wave device disclosed in Patent Document 1, electrodes including an IDT are formed at a boundary between a piezoelectric substance and a dielectric substance, and an SH type boundary acoustic wave propagating along the boundary is used.

In this boundary acoustic wave device described above, the thickness of the IDT is determined so that the acoustic velocity of the SH type boundary acoustic wave is lower than the acoustic velocity of a slow transverse wave propagating through the dielectric substance and the acoustic velocity of a slow transverse wave propagating through the piezoelectric substance. In addition, when $LiNbO_3$ is used as the piezoelectric substance, and when $SiO_2$ is used as the dielectric substance, an electrode thickness range in which the propagation loss is decreased to 0 and a cut angle range of $LiNbO_3$ in which unnecessary spurious response is decreased are shown.

[Patent Document 1] WO2004/070946

Disclosure of Invention

In a boundary acoustic wave device, depending on applications, a significantly small change in frequency characteristics with the change in temperature, that is, a smaller absolute value of TCF, may be required in some cases. In the boundary acoustic wave device disclosed in Patent Document 1, the structure is shown in which $LiNbO_3$ is used as the piezoelectric substance and $SiO_2$ is used as the dielectric substance. The temperature coefficient of frequency TCF of $LiNbO_3$ is a negative value, and the temperature coefficient of frequency TCF of $SiO_2$ is a positive value. Accordingly, when $LiNbO_3$ and $SiO_2$ are used, the absolute value of the temperature coefficient of frequency TCF can be decreased.

In the meantime, an electrode thickness at which the propagation loss of an SH boundary acoustic wave is decreased to 0 varies in accordance with the duty ratio of the IDT. For example, when the duty ratio is decreased, in the thickness range of the IDT disclosed in Patent Document 1, the propagation loss is not decreased to 0 and is relatively large in some cases. In the case as described above, even if TCF can be decreased, the loss inevitably increases.

On the other hand, when the duty ratio of the IDT is increased, it is possible to decrease the propagation loss to 0. However, when the duty ratio is increased, the absolute value of TCF increases, and as a result, frequency temperature characteristics are degraded. In addition, when the duty ratio is high, the variation in frequency caused by fluctuation in linewidth decreases, and consequently, the yield is advantageously improved.

An object of the present invention is to solve the above problems of the conventional techniques to provide a boundary acoustic wave device which has a low temperature coefficient of frequency TCF and insertion loss when the duty ratio is low, and which has a low loss and the yield of which is not likely to decrease when the duty ratio is high.

According to a first aspect of the present invention, in a boundary acoustic wave filter which includes: a piezo-electric substance composed of $LiNbO_3$ having a surface obtained by rotating a Y axis by $15° \pm 10°$ as a primary surface; a dielectric substance which is composed of a silicon oxide and which is laminated to the piezoelectric substance; and an electrode structure which is disposed at a boundary between the piezoelectric substance and the dielectric substance and which includes an IDT to utilize a boundary acoustic wave propagating along the boundary, a boundary acoustic wave device is provided in which when the density of the IDT, the thickness thereof, the wavelength determined by the period of electrode fingers of the IDT, and the duty ratio thereof are represented by p ($kg/m^3$), H ($\mu m$), $\lambda$ ($\mu m$), and x, respectively, x and the product of $H/\lambda$ and p are set in the range that satisfies the following formula (1), and the IDT has an Au-based metal layer composed of Au or an alloy primarily composed of Au, the IDT furthermore has a frequency adjusting film and is composed of a laminate metal film including layers laminated in the following sequence: the frequency adjusting film/Ti/Pt/the Au-based metal layer/Pt/Ti.

[Mathematical Expression 1]

$$(H/\lambda)\times\rho > 70.7924(x+0.055)^{(-2.0884)}+797.09 \qquad \text{Formula (1)}$$

Although the upper limit of the thickness of the IDT is not particularly limited in order to achieve the object of the present invention, due to the restriction from a manufacturing point of view, the thickness is preferably set to 0.35 $\lambda$ or less.

The silicon oxide forming the above dielectric substance is preferably $SiO_2$, and in the case of $SiO_2$, the acoustic velocity of the boundary acoustic wave is preferably set to 93% or less of 3,757 m/sec which is the acoustic velocity of a transverse wave of $SiO_2$. In this case, the insertion loss can be further decreased.

The IDT may be composed of various metals and alloys; however, in accordance with a device related to but not part of the present invention, the IDT is composed of

Au or an alloy primarily composed of Au, and when the thickness of Au or an alloy primarily composed of Au is represented by $H_{Au}$, the thickness $H_{Au}$ is set in the range that satisfies the following formula (2). In this case, since the thickness $H_{Au}$ satisfies the formula (2), when a low duty ratio is selected, the absolute value of TCF and the insertion loss can be decreased, and when a high duty ratio is selected, the yield is good, and a decrease in loss can be achieved.

In this specification, a low duty ratio is defined as a duty ratio of less than 0.5, and a high duty ratio is defined as a duty ratio of more than 0.5. That is, the duty of the IDT is generally set to 0.5, and by using a duty ratio of 0.5 as a reference, a duty ratio of less than 0.5 is defined as a low duty ratio, and a duty ratio of more than 0.5 is defined as a high duty ratio.

[Mathematical Expression 2]

$$H_{Au}/\lambda > 0.003668(x+0.055)^{(-2.0884)}+0.0413 \qquad \text{Formula (2)}$$

In accordance with another device related to but not part of the present invention, the IDT is composed of Cu or an alloy primarily composed of Cu, and when the thickness of Cu or an alloy primarily composed of Cu is represented by $H_{Cu}$, the thickness $H_{Cu}$ is set in the range that satisfies the following formula (3).

[Mathematical Expression 3]

$$H_{Cu}/\lambda > 0.007927(x+0.055)^{(-2.0884)}+0.08926 \qquad \text{Formula (3)}$$

In this case, since the thickness $H_{Cu}$ is set in the range shown by the formula (3), when a low duty ratio is selected, the absolute value of TCF and the insertion loss can be decreased, and when a high duty ratio is selected, an improvement in yield and a decrease in insertion loss can be achieved.

According to the present invention, H indicates the thickness ($\mu$m) of the IDT, and $\lambda$ indicates the wavelength ($\mu$m) determined by the period of electrode fingers of the IDT. Hence, $H/\lambda$ is a normalized thickness of the IDT, and $H_{Au}/\lambda$ or $H_{Cu}/\lambda$ represents the normalized thicknesses of the IDT when Au or Cu is used therefor, respectively, in the related devices.

According to the present invention, the IDT is formed of a laminate metal film including a plurality of metal layers laminated to each other, and when the average density obtained in accordance with the thickness ratio among the metal layers thus laminated is represented by the above $\rho$ ($kg/m^3$), and the total thickness of the laminate metal film is represented by the above H, it is designed that the product of H and $\rho$ satisfies the above formula (1). As described above, the IDT may be formed of a laminate metal film, and when materials for the metal layers forming the laminate metal film are variously selected, the adhesion between the piezoelectric substance and the dielectric substance may be increased, or the electric power resistance may be improved.

According to the present invention the IDT includes an Au-based metal layer composed of Au or an alloy primarily composed of Au and further includes a frequency adjusting film. The IDT is composed of a laminate metal film including layers laminated in the following sequence: the frequency-adjusting film/Ti/Pt/the Au-based metal layer/Pt/Ti. The diffusion between Au and Ti is suppressed, and the adhesion to the piezoelectric substance and the dielectric substance is improved by the Ti films. Hence, the reliability of the boundary acoustic wave filter can be improved. The thickness of Pt is preferably set in the range of 3 to 10 nm. In this case, the diffusion of Au from the Au-based metal layer can be reliably suppressed, and the electrode finger resistance is decreased, so that the insertion loss can be further decreased.

According to the present invention, the duty ratio of the IDT is preferably set in the range of 0.3 to 0.7 and is more preferably set in the range of 0.3 to 0.4. When the duty ratio of the IDT is set in the range of 0.3 to 0.7, the IDT is easily formed, and when the duty ratio is set in the range of 0.3 to 0.4, the IDT is easily formed, and TCF and the loss can also be decreased.

(Advantages)

In the boundary acoustic wave device according to the present invention, since the electrode structure including the IDT is disposed at the boundary between the piezoelectric substance composed of $LiNbO_3$ having a surface obtained by rotating a Y axis by 15°±10° as a primary surface and the dielectric substance which is composed of a silicon oxide, and since the product of the normalized thickness H/λ and the density p of the IDT and the duty ratio x thereof are set in the range that satisfies the above formula (1), the loss can be decreased.

As the duty ratio of the IDT is decreased, the absolute value of TCF decreases, and the frequency temperature characteristics can be improved.

On the other hand, as the duty ratio of the IDT is increased, since the linewidth dependency of frequency decreases, the variation in frequency caused by fluctuation in linewidth decreases. Accordingly, the yield is improved.

Hence, the most optimum value of the duty ratio may be selected in accordance with applications. However, the thickness of the IDT at which the propagation loss sufficiently decreases varies depending on the duty ratio. Since the thickness of the IDT is determined also in consideration of the duty ratio, when the above formula (1) is satisfied, the temperature coefficient of frequency TCF and the insertion loss can both be decreased when the duty ratio is relatively low, so that the improvement in frequency temperature characteristics and the decrease in loss can be achieved. In addition, when a relatively high duty ratio is selected, a boundary acoustic wave device can be provided which has a low loss, and the yield of which is good.

Brief Description of Drawings

[Fig. 1] Figs. 1(a) and 1(b) are a schematic front cross-sectional view of a boundary acoustic wave filter according to one embodiment of the present invention and a schematic plan view showing an electrode structure, respectively.

[Fig. 2] Fig. 2 is a view showing the relationship between the acoustic velocity of a boundary acoustic wave and the thickness of a Au film, which is obtained when the duty ratio is set to 0.30, 0.40, 0.50, and 0.60.

[Fig. 3] Fig. 3 is a view showing the relationship between the duty ratio of an IDT and a normalized thickness $H_{Au}/λ$ of the IDT at which a boundary acoustic wave is confined.

[Fig. 4] Fig. 4 is a view showing the relationship between the temperature coefficient of frequency TCF and a normalized thickness H/λ of an IDT composed of a NiCr/Ti/Pt/Au/Pt/Ti laminate metal film in which the thickness of the Au layer is variously changed.

[Fig. 5] Fig. 5 is a view showing the relationship between the thickness of Au forming an IDT and a sheet resistance thereof.

[Fig. 6] Fig. 6 is a view showing the relationship between the duty ratio and the product of a density p and a normalized thickness H/λ in the case in which a boundary acoustic wave is confined.

[Fig. 7] Fig. 7 is a view showing the relationship between a normalized thickness $H_{Cu}/k$ of an IDT composed of Cu and the duty ratio in the case in which a boundary acoustic wave is confined.

[Fig. 8] Fig. 8 is a view showing the relationship between the temperature coefficient of frequency TCF and the duty ratio of an IDT which is composed of a NiCr/Ti/Pt/Au/Pt/Ti laminate metal film and which has a normalized thickness H/λ of 6.6%.

[Fig. 9] Fig. 9 is a view showing the relationship between the duty ratio and the acoustic velocity of a boundary acoustic wave.

[Fig. 10] Fig. 10 is a partially enlarged cross-sectional view schematically showing an electrode structure when an IDT used in a boundary acoustic wave filter of the present invention is composed of a laminate metal film.

Reference Numerals

1　　　boundary acoustic wave filter

2      piezoelectric substance
3      dielectric substance
4      electrode structure
5      IDT
6      reflector
11     IDT
11a    Ti layer
11b    Pt layer
11c    Au layer
11d    Pt layer
11e    Ti layer
11f    NiCr layer

Best Modes for Carrying Out the Invention

Hereinafter, concrete embodiments of the present invention will be described with reference to the drawings, so that the present invention will be clarified.

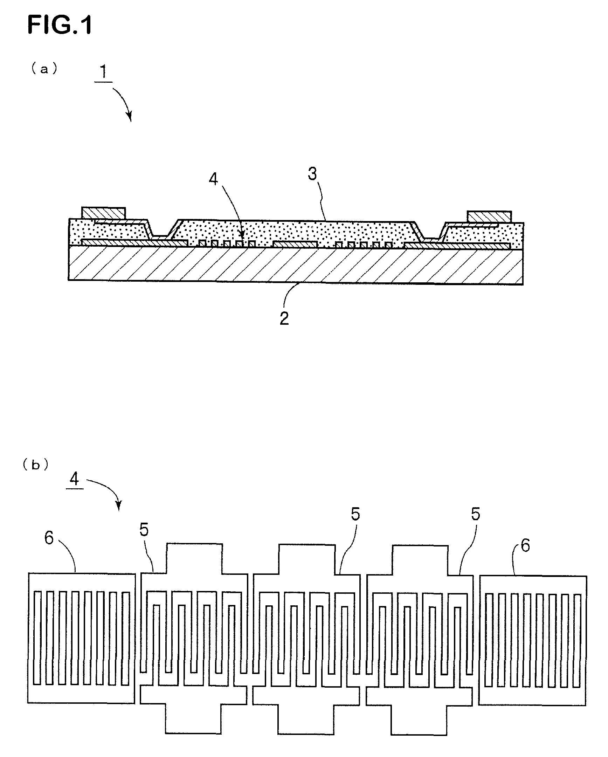

Fig. 1(a) is a front cross-sectional view schematically showing a boundary acoustic wave filter according to one embodiment of the present invention, and Fig. 1(b) is a schematic plan view showing an electrode structure including an IDT

A boundary acoustic wave filter 1 has a piezoelectric substance 2 and a dielectric substance 3. The piezoelectric substance 2 is composed of $LiNbO_3$ having a surface obtained by rotating a Y axis by $15° \pm 10°$ as a primary surface. In addition, the dielectric substance 3 is composed of a silicon oxide, and in this embodiment, $SiO_2$ is used as the silicon oxide. However, the dielectric substance 3 may be composed of a silicon oxide other than $SiO_2$. At a boundary between the piezoelectric substance 2 and the dielectric substance 3, an electrode structure 4 shown in Fig. 1(b) is formed. That is, a plurality of IDTs 5 and reflectors 6 which are disposed at two sides in a propagation direction of a boundary acoustic wave are formed. Accordingly, a longitudinally coupled resonator-type boundary acoustic wave filter is formed.

In the boundary acoustic wave filter of this embodiment, the electrode structure 4 including the IDTs 5 is formed using a metal having a high density at the boundary between the piezoelectric substance 2 composed of $LiNbO_3$ and the dielectric substance 3 composed of $SiO_2$. Accordingly, when the acoustic velocity of an SH type boundary acoustic wave propagating along a boundary portion is set equal to or less than the acoustic velocity of a transverse wave of the piezoelectric substance 2 and the acoustic velocity of a transverse wave of the dielectric substance 3, the SH type boundary acoustic wave is confined at the boundary.

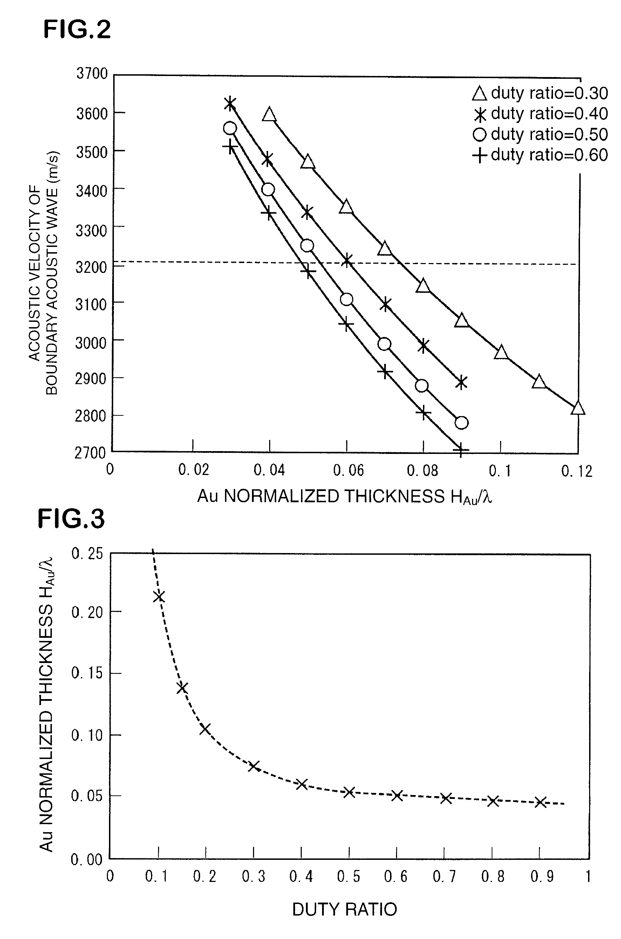

When the thickness of the IDT 5 is small, the acoustic velocity of the boundary acoustic wave is not sufficiently decreased, and the boundary acoustic wave is not easily confined. As a result, the loss is increased. Hence, in order to confine the boundary acoustic wave, the thickness of the IDT 5 must be set to a predetermined value or more, that is, the lower limit of the thickness of the IDT 5 is present. Hereinafter, this lower limit of the thickness is called a cut-off thickness. The cut-off thickness can be determined by the acoustic velocity of the boundary acoustic wave. Fig. 2 is a view showing the relationship between a normalized thickness $H_{Au}/\lambda$ of an IDT composed of Au and the acoustic velocity of an SH type boundary acoustic wave in a boundary acoustic wave filter related to but not part of the invention and having a $SiO_2/Au/LiNbO_3$ structure. In this related device, a laminate structure represented by $SiO_2/Au/LiNbO_3$ indicates a structure in which the IDT composed of Au is formed at the boundary between $SiO_2$ and $LiNbO_3$.

The acoustic velocity of the SH type boundary acoustic wave shown in Fig. 2 is an acoustic velocity at a lower end of a stopband obtained by the finite element method. This acoustic velocity corresponds to that at a low-frequency side end of a passband of the boundary acoustic wave filter 1. As apparent from Fig. 2, it is found that in each case in which the duty ratio of the IDT is 0.30, 0.40, 0.50, or 0.60, as the thickness of Au is decreased, the acoustic velocity increases, and the boundary acoustic wave is not easily confined. In addition, from Fig. 2, at each duty ratio, a thickness value of Au at which the acoustic velocity of the boundary acoustic wave is 3,210 m/sec can be obtained. In the same manner as described above, when the duty ratio is 0.1 to 0.9, a thickness of Au at which the acoustic velocity of the boundary acoustic wave is 3,210 m/sec was obtained. The results are shown in Fig. 3. Fig. 3 shows the normalized thickness $H_{Au}/\lambda$ of an IDT composed of Au at which the acoustic velocity of the boundary acoustic wave is 3,210 m/sec in a duty ratio range of 0.1 to 0.9. As shown in Fig. 2, at each duty ratio, when the thickness of the IDT composed of Au is larger than a thickness at which the acoustic velocity is 3,210 m/sec, the acoustic velocity of the boundary acoustic wave is lower than 3,210 m/sec, and the boundary acoustic wave can be confined at the boundary portion. Hence, when the thickness is set equal to or more than the thickness shown by the dotted line in Fig. 3, the boundary acoustic wave can be confined at the boundary.

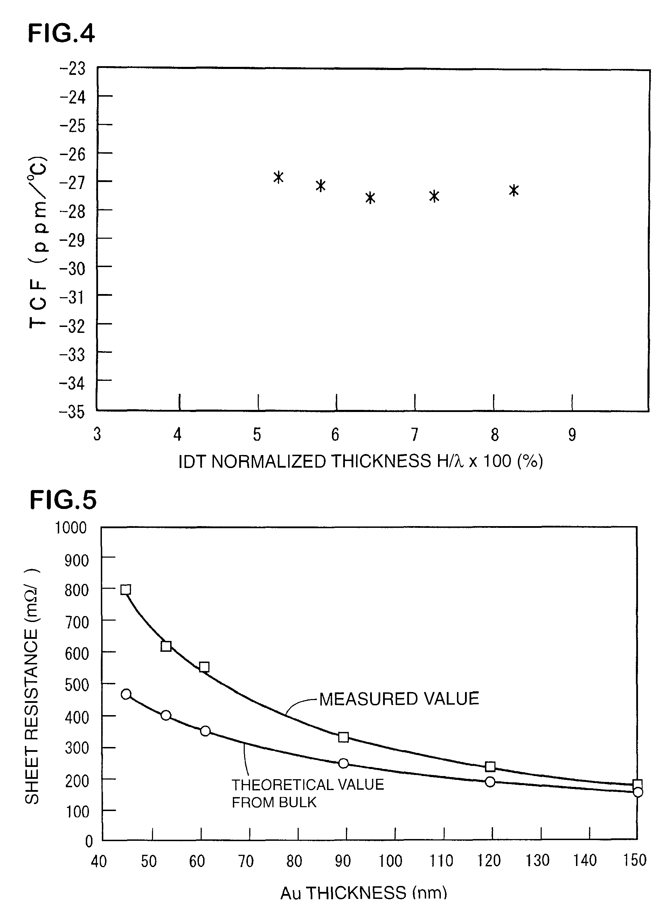

In addition, Fig. 4 is a view showing the relationship between the temperature coefficient of frequency TCF (ppm/°C) and a normalized thickness $H/\lambda$ of an IDT of the boundary acoustic wave filter 1 obtained when the thickness of the IDT is variously changed which is composed of a NiCr/Ti/Pt/Au/Pt/Ti laminate metal film, according to an embodiment of the invention, in which the thickness of the Au layer is variously changed. The film thicknesses of the layers of NiCr, Ti, Pt, Pt, and Ti other than the Au layer are each fixed to 10 nm.

As apparent from Fig. 4, in the region in which the thickness of the IDT is small, that is, in the region in which $H/\lambda \times 100$ (%) is 6.5% or less, as the thickness of the Au layer is increased, TCF increases and is degraded. Although TCF is further degraded when the thickness of the Au layer is a thickness of approximately 7.0%, it is found that when the thickness of the Au layer is further increased, TCF conversely decreases and is improved.

In addition, Fig. 5 is a view showing the change in sheet resistance when the IDT is formed only from Au, and when the thickness (nm) thereof is changed. As apparent from Fig. 5, it is found that, as the thickness of the IDT is increased, the sheet resistance of the electrode decreases and the resistance of each electrode finger of the IDT decreases. Hence, the insertion loss can be decreased. Accordingly, as the thickness of the IDT is increased, the insertion loss and TCF are improved; hence, it is found that, in order to obtain improved characteristics, the upper limit of the thickness of the IDT is not particularly limited.

However, because of the restriction from a process point of view, the upper limit is present. For example, when a $SiO_2$ film is formed by sputtering after the IDT is formed on $LiNbO_3$, as the thickness of the IDT is increased, voids may be generated in $SiO_2$ or the coverage thereof may be degraded in some cases. Hence, the thickness of the IDT is preferably set to 0.35 $\lambda$ or less because of the restriction from a process point of view.

As described above, it is understood that the lower limit of the thickness of the IDT is determined by the cut-off thickness described above, and that in order to improve the characteristics, the upper limit is not particularly present. In addition, it is found that the cut-off thickness depends on the duty ratio. When the duty ratio is decreased, the cut-off thickness is increased because of a mass load decreased on the identical thickness decreases.

The thickness of the IDT at which cut-off occurs is substantially determined by the density of an electrode material, and the density and the cut-off thickness have an inverse relationship. Hence, it is found that the product of the density of the IDT and the thickness thereof must be set to a predetermined value or more.

The change in cut-off thickness with the change in duty ratio obtained when the IDT composed of Au is used as the IDT is shown in Fig. 3 as described above. Hence, a value obtained when the cut-off thickness obtained in Fig. 3 is multiplied by a Au density of 19,300 ($kg/m^3$) is a value obtained when a cut-off thickness of an IDT composed of a general metal is multiplied by a density p of the IDT. This value corresponds to the following formula (1A).

[Mathematical Expression 4]

$$(H/\lambda) \times \rho = 70.7924(x+0.055)^{(-2.0884)} + 797.09 \qquad \text{Formula (1A)}$$

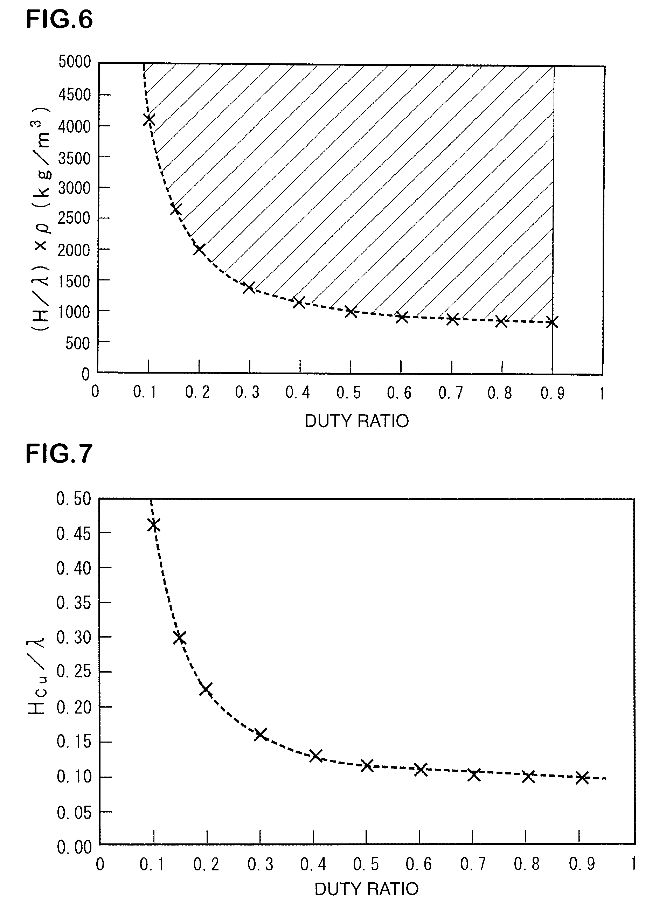

Accordingly, it is found that the range in which the thickness is larger than that represented by the formula (1A), that is, the range hatched with oblique lines shown in Fig. 6, is the range in which TCF and the loss can be decreased.

Hence, in this embodiment, the product of the thickness $H/\lambda$ of the IDT and the density thereof is set in the range that satisfies the following formula (1).

[Mathematical Expression 5]

$$(H/\lambda) \times \rho > 70.7924(x+0.055)^{(-2.0884)} + 797.09 \qquad \text{Formula (1)}$$

In Formula (1), although the density of the IDT is represented by p, when the IDT is composed of Au, since the density p is 19,300 ($kg/m^3$), instead of the formula (1), the thickness $H_{Au}/\lambda$ is in the range that satisfies the following formula (2).

[Mathematical Expression 6]

$$H_{Au}/\lambda > 0.003668(x+0.055)^{(-2.0884)} + 0.0413 \qquad \text{Formula (2)}.$$

That is, the thickness $H_{Au}/\lambda$ may be set in the range in which the thickness is equal to or more than that on the dotted line shown in Fig. 3.

In addition, when Cu is used for the IDT in a device related to but not part of the invention, since the density of Cu is 8,930 ($kg/m^3$), the above formula (1) may be divided by the density of Cu. Hence, the thickness $H_{Cu}/\lambda$ may be set

in the range that satisfies the following formula (3)

[Mathematical Expression 7]

$$H_{Cu}/\lambda > 0.007927(x+0.055)^{(-2.0884)}+0.08926 \qquad \text{Formula (3)}$$

That is, the thickness $H_{Cu}/\lambda$ may be set the range in which the thickness is equal to or more than that on the dotted line shown in Fig. 7.

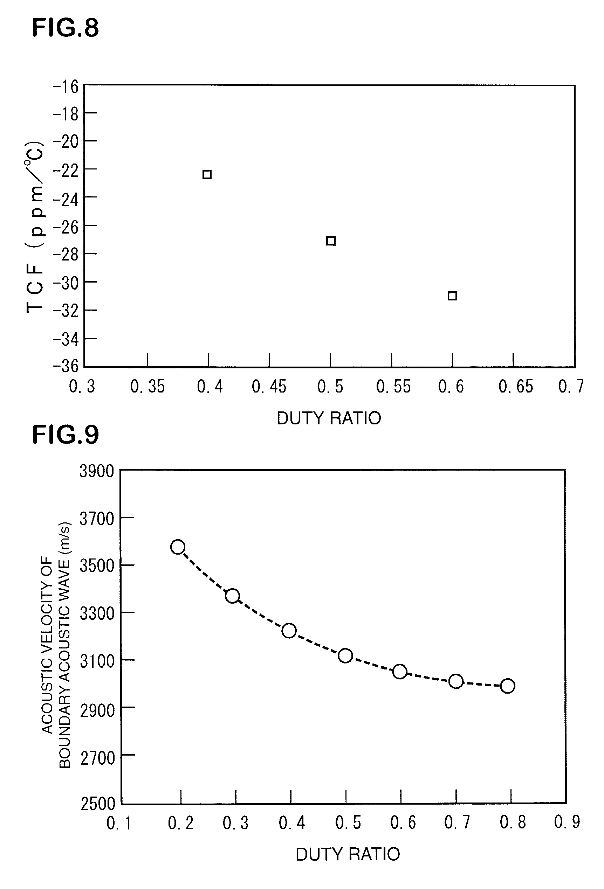

Fig. 8 shows the change in temperature coefficient of frequency TCF with the change in duty ratio of the IDT, and the results are shown which are obtained when the IDT has a laminate structure of NiCr/Ti/Pt/Au/Pt/Ti, and when the normalized thickness $H/\lambda$ is set to 6.6%. As apparent from Fig. 8, it is found that when the duty ratio is low, such as less than 0.5, the absolute value of TCF decreases, and a superior temperature coefficient of frequency can be obtained.

In addition, Fig. 9 is a view showing the relationship between the acoustic velocity of the boundary acoustic wave and the duty ratio obtained when the IDT is composed of Au.

From Fig. 9, it is found that when the duty ratio is more than 0.5, that is, when the duty ratio is in a high-ratio range, the duty ratio dependency of the acoustic velocity of the boundary acoustic wave decreases, that is, the dependency of frequency characteristics on the electrode finger linewidth decreases. Accordingly, it is found that since the variation in characteristics caused by fluctuation in width of each electrode finger is not likely to occur during manufacturing, the yield can be improved. Hence, as apparent from Figs. 8 and 9, it is found that since the above-described effect can be obtained in both cases in which the duty ratio is decreased to less than 0.5 and is increased to more than 0.5, the duty ratio may be selected in accordance with desired applications. That is, it is found that TCF and the loss can both be decreased when the duty ratio is decreased to less than 0.5, and that in addition, a decrease in loss and an improvement in yield can both be achieved when the duty ratio is increased to more than 0.5. Hence, in accordance with desired applications, when the duty ratio is selected from the range in which the above formula (1), (2), or (3) holds, the loss can be decreased.

When the duty ratio and the thickness of the IDT electrode are set in the range defined by the above formula (1) using a material having the density p, are set in the range defined by the above formula (2) using Au in the related device, or are set in the range defined by the above formula (3) using Cu in the related device, the propagation loss of the boundary acoustic wave propagating along the boundary between $SiO_2$ and $LiNbO_3$ becomes 0, and the acoustic velocity of the boundary acoustic wave at a low-frequency side end of the passband is decreased to 3,210 m/sec or less. That is, at a low-frequency side of the passband, the acoustic velocity of the boundary acoustic wave is set to 85.4% or less of 3,757 m/sec which is the transverse acoustic velocity of $SiO_2$. The reason the acoustic velocity of the boundary acoustic wave at a low-frequency side end of the passband is set to 85.4% or less of the transverse acoustic velocity of $SiO_2$ is as follows.

When the duty ratio is low, the thickness of the IDT electrode disposed at the boundary between $SiO_2$ and $LiNbO_3$ is set larger than that when the duty ratio is high so that the acoustic velocity of the SH boundary acoustic wave is sufficiently lower than 3,757 m/sec which is the acoustic velocity of a slow transverse wave propagating through $SiO_2$ and 4,031 m/sec which is the acoustic velocity of a slow transverse wave propagating through $LiNbO_3$.

In the case of a band pass filter, the acoustic velocity (wavelength×frequency) of a boundary acoustic wave in the whole passband must be sufficiently decreased as compared to 3,757 m/sec which is the acoustic velocity of a slow transverse wave propagating through $SiO_2$.

Even in a band pass filter having a broad band width which is used for a mobile phone, the band width is only approximately 7% of a central frequency. On the other hand, the wavelength, which is an electrode finger pitch of the IDT electrode, is constant. Accordingly, the acoustic velocity of the boundary acoustic wave at a low-frequency side end of the passband is 7% or less of the acoustic velocity of the boundary acoustic wave at a high-frequency side end of the passband.

Furthermore, a margin of 7% is set between the acoustic velocity of the boundary acoustic wave at a high-frequency side end of the passband and 3,757 m/sec which is the acoustic velocity of a slow transverse wave propagating through $SiO_2$. By this margin, the boundary acoustic wave can be sufficiently confined at the boundary between $SiO_2$ and $LiNbO_3$.

Accordingly, the acoustic velocity of the boundary acoustic wave at a high-frequency side end of the passband may be set to not more than 3,495 m/sec which is 93% of the acoustic velocity of a slow transverse wave propagating through $SiO_2$. In addition, the acoustic velocity of the boundary acoustic wave at a low-frequency side end of the passband may be set to not more than 3,210 m/sec which is 85.4% of the acoustic velocity of a slow transverse wave propagating through $SiO_2$.

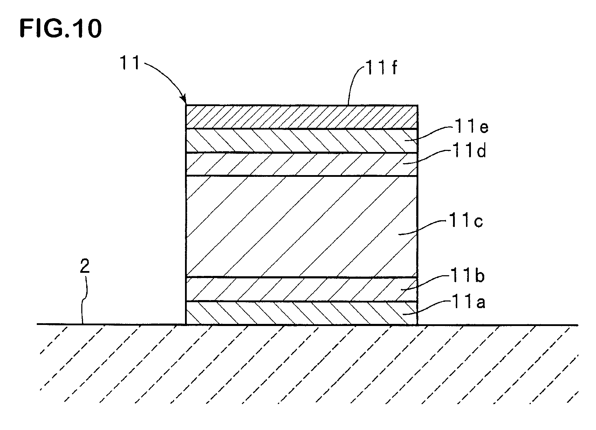

In the boundary acoustic wave device according to the present invention, a laminate metal film including a plurality of metal layers laminated to each other is used. For example, in an IDT 11 shown in Fig. 10, 6 metal layers are laminated on the piezoelectric substance 2 composed of LiNbO$_3$. The 6 metal layers are, from the LiNbO$_3$ side, a Ti layer 11a, a Pt layer 11b, an Au layer 11c, a Pt layer 11d, a Ti layer 11e, and a NiCr layer 11f.

As described above, according to the invention the IDT 11 is formed by laminating a plurality of metal layers. In this case, as the density p of the IDT 11, the average density may be used which is obtained by dividing the sum of the products of the thicknesses of the metal layers and the densities of metals forming the respective metal layers by the sum of the thicknesses of the metal layers.

As with the IDT 11, when the IDT 11 is formed of the laminate metal layer, the adhesion to LiNbO$_3$ and SiO$_2$ can be improved. That is, in the case of Au, the adhesion to LiNbO$_3$ and SiO$_2$ may not be sufficient in some cases. On the other hand, in the above laminate metal film, since the Ti layer 11a is provided, the adhesion to LiNbO$_3$ can be improved. In addition, when the Ti layer lie is provided, the adhesion to the NiCr layer 11f provided thereon can be improved. When the Ti layer lie is directly adhered to SiO$_2$, that is, when the NiCr layer 11f is not provided, the adhesion to SiO$_2$ can also be improved thereby.

In addition, the NiCr layer 11f disposed at the topmost position is provided to perform frequency adjustment. After an NiCr film is formed, the frequency adjustment can be performed by decreasing the thickness thereof, or the frequency can be adjusted by forming the NiCr layer to have a large thickness. That is, the variation in frequency caused by the linewidth and the thickness of the electrode can be suppressed by adjusting the thickness of the NiCr layer 11f.

In addition, the Pt layers 11b and 11d are provided to prevent the diffusion of Au. That is, when the Au layer 11c is in direct contact with the Ti layers 11a and 11e, mutual diffusion may occur between Au and Ti by heating or the like. Accordingly, in order to prevent the diffusion, the Pt layers 11b and 11d are inserted.

Since the density of Pt is high, when the Pt layers are laminated without changing the thickness of the Au layer, influence on the thickness of the IDT 11 is increased, and the characteristics are changed. Accordingly, the thickness of the Au layer is preferably decreased so as to suppress the influence.

However, since the resistivity of Pt is higher than that of Au, when the thicknesses of the Pt layers are increased, and when the thickness of the Au layer 11c is decreased, the resistance of each electrode finger increases, and as a result, the loss increases. Hence, the thickness of each of the Pt layers 11b and 11d is preferably set so as to prevent the diffusion between Au and Ti and so as not to increase the loss. According to experiments carried out by the inventor of the present invention, it was confirmed that when the thickness of the Pt layer is set to 3 nm or more, the diffusion between Au and Ti can be prevented, and when the thickness of the Pt layer is set to 10 nm or less, an increase in insertion loss does not so much occur. Hence, the thickness of each of the Pt layers 11b and 11d is preferably set in the range of 3 to 10 nm.

In addition, the duty ratio of the IDT is preferably set in the range of 0.30 to 0.70 and is more preferably set in the range of 0.30 to 0.40. In actually manufacturing a boundary acoustic wave filter, when the linewidth of each electrode finger of the IDT is similar to the width of the gap between the electrode fingers, manufacturing can be easily performed. That is, when the duty ratio is close to 0.50, manufacturing can be easily performed. Accordingly, when the duty ratio is set in the range close to 0.5, that is, in the range of 0.30 to 0.70, the loss can be decreased in accordance with the present invention without complicating steps of manufacturing the IDT.

Since manufacturing can be easily performed, and TCF and the loss can be decreased, the duty ratio is more preferably set in the range of 0.30 to 0.40.

According to the present invention, as shown in Fig. 10, the IDT is composed of a laminate metal film including an Au-based metal layer.

In addition, the boundary acoustic wave filter of the present invention is not only applied to a filter having the electrode structure in a schematic plan view shown in Fig. 1(b) but is also applied to boundary acoustic wave filters having various electrode structures in a schematic plan view.

**Claims**

**1.** A boundary acoustic wave device (1) comprising:

a piezoelectric substance (2) composed of LiNbO$_3$ having a surface obtained by rotating a Y axis by 15°±10° as a primary surface;
a dielectric substance (3) which is composed of a silicon oxide and which is laminated to the piezoelectric substance; and
an electrode structure (4) which is disposed at a boundary between the piezoelectric substance (2) and the dielectric substance (3) and which includes an IDT (5) to utilize a boundary acoustic wave propagating along the boundary;
wherein, when the density of the IDT (5), the thickness thereof, the wavelength determined by the period of electrode fingers of the IDT, and the duty ratio thereof are represented by p (kg/m$^3$), H ($\mu$m), $\lambda$ ($\mu$m), and x, respectively, x and the product of H/$\lambda$ and p are set in the range that satisfies the following formula (1):
[Mathematical Expression 1]

$$(H/\lambda) \times \rho > 70.7924(x+0.055)^{(-2.0884)}+797.09 \qquad \text{Formula (1);}$$

wherein the IDT has an Au-based metal layer composed of Au or an alloy primarily composed of Au;
wherein the IDT furthermore has a frequency adjusting film;
wherein the IDT is composed of a laminate metal film (11) including layers laminated in the following sequence: the frequency adjusting film/Ti/Pt/the Au-based metal layer/Pt/Ti (11f/11e/11d/11c/11b/11a); and
wherein the above $\rho$ (kg/m$^3$) represents the average density of the IDT obtained in accordance with a thickness ratio of each of the metal layers laminated to each other, and H above represents the total thickness of the laminate metal film.

2. The boundary acoustic wave device (1) according to Claim 1, wherein the duty ratio of the IDT (5) is in the range of 0.3 to 0.4.

3. The boundary acoustic wave device (1) according to Claim 1 or 2, wherein the silicon oxide is SiO$_2$, and the acoustic velocity of the boundary acoustic wave is not more than 93% of 3,757 m/sec which is a transverse wave velocity of SiO$_2$.

4. The boundary acoustic wave device (1) according to Claim 1, wherein the thicknesses of the Pt layers (11b,11d) are each in the range of 3 to 10 nm.

**Patentansprüche**

1. Grenzschallwellenvorrichtung (1), umfassend:

eine piezoelektrische Substanz (2), die aus LiNbO$_3$ besteht, die eine Fläche, die durch Drehen einer Y-Achse um 15°±10° erhalten wird, als eine primäre Fläche aufweist,
eine dielektrische Substanz (3), die aus einem Siliziumoxid besteht und die an die piezoelektrische Substanz laminiert ist, und
eine Elektrodenstruktur (4), die an einer Grenze zwischen der piezoelektrischen Substanz (2) und der dielektrischen Substanz (3) angeordnet ist und die einen IDT (5) enthält, um eine Grenzschallwelle zu verwenden, die sich entlang der Grenze ausbreitet,
wobei, wenn die Dichte des IDT (5), seine Dicke, die Wellenlänge, die anhand der Periode der Elektrodenfinger des IDT bestimmt wird, und sein Metallisierungsverhältnis durch p (kg/m$^2$), H ($\mu$m), A ($\mu$m) bzw. x dargestellt werden, x und das Produkt von H/$\lambda$ und p auf einen Bereich eingestellt werden, der die folgende Formel (1) erfüllt:
[Mathematischer Ausdruck 1]

$$(H/\lambda)xp > 70,7924(x+0,055)^{(-2,0884)}+797,09 \qquad \text{Formel (1),}$$

wobei der IDT eine Au-basierte Metallschicht hat, die aus Au oder einer Legierung besteht, die überwiegend aus Au besteht,
wobei der IDT ferner einen Frequenzjustierfilm aufweist,
wobei der IDT aus einem Laminatmetallfilm (11) besteht, der Schichten enthält, die in der folgenden Reihenfolge laminiert sind: der Frequenzjustierfilm / Ti / Pt / die Au-basierte Metallschicht / Pt / Ti (11f/11e/11 d/11 c/11 b/11a), und
wobei das oben erwähnte $\rho$ (kg/m$^3$) die durchschnittliche Dichte des IDT repräsentiert, die gemäß einem Dickenverhältnis einer jeden der miteinander laminierten Metallschichten erhalten wird, und das oben erwähnte H die Gesamtdicke des Laminatmetallfilms repräsentiert.

2. Grenzschallwellenvorrichtung (1) nach Anspruch 1, wobei das Metallisierungsverhältnis des IDT (5) in einem Bereich von 0,3 bis 0,4 liegt.

**3.** Grenzschallwellenvorrichtung (1) nach Anspruch 1 oder 2, wobei das Siliziumoxid $SiO_2$ ist und die Schallgeschwindigkeit der Grenzschallwelle maximal 93 % von 3,757 m/s beträgt, was eine Transversalwellengeschwindigkeit von $SiO_2$ ist.

**4.** Grenzschallwellenvorrichtung (1) nach Anspruch 1, wobei die Dicken der Pt-Schichten (11 b, 11 d) jeweils im Bereich von 3 bis 10 nm liegen.

**Revendications**

**1.** Dispositif à onde acoustique limite (1) comprenant :

un substance piézoélectrique (2) composée de $LiNbO_3$ ayant, en tant que surface principale, une surface obtenue en faisant tourner un axe Y de $15° \pm 10°$ ;
une substance diélectrique (3) qui est composée d'un oxyde de silicium et qui est stratifiée sur la substance piézoélectrique ; et
une structure d'électrode (4) qui est disposée à une limite entre la substance piézoélectrique (2) et la substance diélectrique (3) et qui inclut un transducteur interdigital (5) pour utiliser une onde acoustique limite se propageant le long de la limite ;
dans lequel, lorsque la densité du transducteur interdigital (5), son épaisseur, la longueur d'onde déterminée par la période des doigts d'électrode du transducteur interdigital, et son rapport cyclique sont représentés par p $(kg/m^3)$, H ($\mu$m), $\lambda$ ($\mu$m) et x, respectivement, x et le produit de $H/\lambda$ et p sont définis dans la plage qui satisfait la formule (1) suivante :
[Expression mathématique 1]

$$(H/\lambda) \times \rho > 70{,}7924(x+0{,}055)^{(-2,0884)}+797{,}09 \qquad \text{Formule (1) ;}$$

dans lequel le transducteur interdigital possède une couche métallique à base d'Au composée d'Au ou d'un alliage principalement composé d'Au ;
dans lequel le transducteur interdigital possède en outre un film d'ajustement de fréquence ;
dans lequel le transducteur interdigital est composé d'un film métallique stratifié (11) incluant des couches stratifiées dans l'ordre suivant : le film d'ajustement de fréquence/Ti/Pt/la couche métallique à base d'Au/Pt/Ti (11f/11e/11d/11c/11b/11a) ; et
dans lequel le p $(kg/m^3)$ ci-dessus représente la densité moyenne du transducteur interdigital obtenue selon un rapport d'épaisseur de chacune des couches métalliques stratifiées les unes sur les autres, et H ci-dessus représente l'épaisseur totale du film métallique stratifié.

**2.** Dispositif à onde acoustique limite (1) selon la revendication 1, dans lequel le rapport cyclique du transducteur interdigital (5) est dans la plage de 0,3 à 0,4.

**3.** Dispositif à onde acoustique limite (1) selon la revendication 1 ou 2, dans lequel l'oxyde de silicium est $SiO_2$, et la vitesse acoustique de l'onde acoustique limite n'est pas supérieure à 93 % de 3,757 m/sec qui est une vitesse d'onde transversale de $SiO_2$.

**4.** Dispositif à onde acoustique limite (1) selon la revendication 1, dans lequel les épaisseurs des couches Pt (11b, 11d) sont chacune dans la plage de 3 à 10 nm.

# FIG.1

(a)

(b)

## FIG.2

## FIG.3

# FIG.4

# FIG.5

**FIG.6**

**FIG.7**

## FIG.8

## FIG.9

## FIG.10

**EP 2 068 442 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004070946 A